(19) Europäisches Patentamt
European Patent Office
Office européen des brevets

(11) Veröffentlichungsnummer: **0 394 739 A2**

# (12) EUROPÄISCHE PATENTANMELDUNG

(21) Anmeldenummer: **90106830.4**

(22) Anmeldetag: **10.04.90**

(51) Int. Cl.5: **G03F 7/09, G03F 7/38**

(30) Priorität: **24.04.89 DE 3913466**

(43) Veröffentlichungstag der Anmeldung: **31.10.90 Patentblatt 90/44**

(84) Benannte Vertragsstaaten: **BE CH DE ES FR GB IT LI NL SE**

(71) Anmelder: **Siemens Aktiengesellschaft**
**Wittelsbacherplatz 2**
**D-8000 München 2(DE)**

(72) Erfinder: **Ahne, Hellmut, Dr.**
**Heideweg 7**
**D-8551 Röttenbach(DE)**
Erfinder: **Leuschner, Rainer, Dr. rer. nat.**
**Buchenweg 2**
**D-8521 Grossenseebach(DE)**
Erfinder: **Sezi, Recai, Dr.-Ing.**
**Weiherstrasse 14**
**D-8551 Röttenbach(DE)**
Erfinder: **Sebald, Michael, Dr. rer. nat.**
**Kirchenteig 3**
**D-8521 Hessdorf(DE)**
Erfinder: **Birkle, Siegfried, Dr. rer. nat.**
**Veit-Stoss-Strasse 46**
**D-8552 Höchstadt(DE)**

## (54) Verfahren zur masshaltigen Strukturübertragung mit einem Zweilagenresist.

(57) Es wird ein Verfahren zur lithographischen Strukturübertragung mit einem Zweilagenresistsystem vorgeschlagen, bei dem der Bottomresist in den zwischen einer Topresiststruktur frei gelegten Bereichen durch chemische Behandlung mit einem in flüssiger Phase vorliegenden Agens gegenüber einem Trockenätzverfahren ätzresistent gemacht wird. Vorzugsweise durch Sylilierung wird so in den freigelegten Bereichen des Bottomresists eine Ätzmaske für den anschließenden Trockenätzprozeß erzeugt, in dem ein negatives Bild der Topresiststruktur entsteht. Über verschiedene Parameter der chemischen Behandlung wird das Verfahren so gesteuert, daß ein exakter 1:1-Strukturübertragung von der Maske auf den Wafer erzeugt wird.

EP 0 394 739 A2

## Verfahren zur maßhaltigen Strukturübertragung mit einem Zweilagenresist

Photoresists dienen zur Definition und Erzeugung von Strukturen auf photolithographischem Weg, wobei eine vorgegebene Struktur von einer Vorlage (Maske) mittels optischer Methoden auf ein Substrat, z.B. einen Wafer, übertragen wird. In einer auf ein Substrat aufgebrachten Hilfsschicht aus Photoresist wird durch bildhafte Belichtung eine gezielte chemische Veränderung in den belichteten Bereichen vorgenommen. Das daraus resultierende unterschiedliche chemische Verhalten von belichteten und unbelichteten Bereichen ermöglicht eine Entwicklung dieses "Bildes", welche auf naßchemischen oder trockenem Weg vorgenommen werden kann.

In der mikroelektronischen Industrie sind Photoresists bei der Herstellung von Halbleiterbauelementen unabdingbar. Mit der fortschreitenden Entwicklung, die sich insbesondere durch eine Verkleinerung der elektronischen Bauelemente bzw. durch eine Erhöhung der Integrationsdichte bei integrierten Bauelementen äußert, werden auch an Photoresists immer höhere Anforderungen gestellt. Kleiner werdende Strukturen erfordern eine höhere Auflösung und einen höheren Kontrast der verwendeten Photoresistsysteme. Bereits heute produzierte Speicherbausteine enthalten kleinste Strukturen von unter 1 µm. Die weitere Entwicklung erfordert jedoch Resistsysteme, mit denen Strukturen von 0,5 µm und weniger erzeugt werden können. Dazu müssen neue Resistsysteme bereitgestellt werden und die entsprechenden Verfahren und die Technologien verbessert werden.

Bisher verwendete naßentwickelbare Einlagenresists, z.B. auf der Basis von Novolackharzen als Basispolymer und Chinonaziden als photoaktive Komponente, können die zukünftigen Anforderungen z.B. Strukturierung mit Excimerlasersteppern im tiefen UV-Bereich zur Erzeugung einer besseren Auflösung, nicht mehr erfüllen.

Eine durch zunehmende Ausnützung der "dritten Dimension" immer stufiger werdende Substrattopographie erfordert zum Ausgleich eine dickere Resistschicht, um bei der Belichtung eine planare Resistoberfläche zu erhalten. Wegen der mit der Wellenlänge der zur Belichtung verwendeten Strahlung kleiner werdenden Fokustiefe können gut aufgelöste Photoresiststrukturen daher nur in dünnen Resistschichten erzeugt werden. Dieses Problem kann nur mit einer Zweilagentechnik gelöst werden, bei der eine dünne obere Resistschicht über einer planarisierenden Hilfsschicht strukturiert wird. Diese Struktur wird nun mittels eines anisotropen Ätzverfahrens in die darunter liegende planarisierende Schicht übertragen. Dies geschieht insbesondere in einem Sauerstoff/Reaktivionenplasma ($O_2$-RIE). Um überhaupt als Ätzmaske dienen zu können, muß die aus der oberen Resistschicht gebildete Struktur eine gegenüber der planarisierenden Schicht ausreichend hohe Ätzresistenz aufweisen. Eine solche kann dem Resist von Anfang an zu eigen sein oder kann erst nach der Strukturierung durch eine geeignete chemische Behandlung erzeugt werden. Eine Ätzresistenz gegenüber Sauerstoffplasma wird durch den Einbau von silziumhaltigen Gruppen in den Resist erzielt. Bekannte alkalisch entwickelbare Topresists enthalten z.B. Siliziumanteile von ca. 10 Gewichtsprozent. Trotz erhöhter Ätzresistenz kommt es wahrend der Strukturübertragung mit dem Ätzplasma dennoch zu einem gewissen Abtrag der Topresiststruktur, bei dem auch ein lateraler Maßverlust entsteht. D.h., daß die durch den Ätzschritt erzeugten Strukturen (Stege) schmaler sind, als auf der Maske vorgegeben.

Eine ausführliche kritische Würdigung der bekannten Verfahren für die Zweilagentechnik ist z.B. auch einem Artikel von R. Sezi et al in SPIE Vol. 811 (1987), S. 172 bis 179, zu entnehmen.

Auch eine nachträgliche Vergütung der Topresiststruktur, d.h. eine nachträgliche Erhöhung der Ätzresistenz nach der Strukturierung des Topresists führt in bekannten Verfahren nicht zu einer Strukturübertragung ohne Maßverlust. In der EP-A 0 136 130 wird z.B. ein Verfahren vorgeschlagen, bei dem eine Novolak-Resiststruktur mit gasförmigem Titanchlorid behandelt wird. Neben einer nie auszuschließenden Kontamination des Wafers mit dem bei der Reaktion entstehenden HCl führt auch dieses Verfahren zu einem lateralen Maßverlust der Topresiststruktur, der für Sub-µm-Strukturen (z.B. im Bereich von 0,5 µm) nicht tolerabel ist.

In anderen Verfahren wird eine erhöhte Ätzresistenz einer Topresiststruktur durch Behandlung mit Hexametyhlcyclotrisilazan, Butylmagnesium, Chlorsilanen oder Aminosilanen erzeugt. Auch diese Verfahren erzeugen einen zu hohen Maßverlust bei der Strukturübertragung, da die zur Erhöhung der Ätzresistenz führende Reaktion überwiegend an der Phasengrenze bzw. an der Oberfläche der Resiststrukturen stattfindet und die ätzresistene Schicht nicht ausreichend dick ist. Auch ist die Durchführung einiger der genannten Verfahren zu aufwendig oder aus anderen praktischen Erwägungen heraus im technischen Maßstab nicht durchzuführen.

Aufgabe der vorliegenden Erfindung ist es daher, ein Verfahren zur Strukturübertragung in der Zweilagentechnik anzugeben, welches einen exakten 1:1-Strukturtransfer von der Maske in den Wafer

ermöglicht, einfach durchzuführen ist und zu hoch aufgelösten Strukturen mit steilen Flanken führt.

Diese Aufgabe wird erfindungsgemäß durch ein Verfahren gelöst, bei dem

a) auf einem Substrat eine erste planarisierende Resistschicht aufgebracht wird,

b) darüber eine zweite, ausreichend dünne photolithographisch strukturierbare Resistschicht erzeugt, über eine Maske belichtet und entwickelt wird, wobei Bereich der ersten Resistschicht freigelegt werden,

c) das Material der ersten Resistschicht in den freigelegten Bereichen mit einem in flüssiger Phase vorliegenden Agens chemisch behandelt wird, um eine Ätzresistenz gegen ein gegebenes Trockenätzverfahren zu erzeugen und

d) dieses Ätzverfahren schließlich durchgeführt wird, um die zweite Resistschicht vollständig, und die erste Resistschicht anisotrop bis auf die freigelegten und chemisch behandelten und veränderten Bereiche abzutragen, wobei die entstehende Struktur aus den chemisch veränderten Bereichen der ersten Resistschicht besteht und ein Negativbild der in der zweiten Resistschicht gebildeten Struktur darstellt.

Weiterhin liegt es im Rahmen der Erfindung, daß die chemische Behandlung eine kontrollierbare isotrope Wirkung aufweist, wobei durch Unterdiffusion unter die aus der zweiten Resistschicht gebildete Struktur auch benachbarte Gebiete der nicht freigelegten Bereiche erfaßt werden, wobei eine Verbreiterung der ätzresistenten Strukturen erzielt wird, und daß das Ausmaß dieser Strukturverbreiterung gesteuert wird.

Weitere Ausgestaltungen der Erfindung sind den Unteransprüchen zu entnehmen.

Geht man von der Tatsache aus, daß sowohl bei Überentwicklung der oberen Resiststruktur eine Verschmälerung der oberen Resiststruktur erreicht wird als auch die Strukturübertragung in die untere Resistschicht mit einem lateralen Maßverlust behaftet ist, so wird im erfindungsgemäßen Verfahren bereits durch die Bildumkehr ein gewisser Ausgleich des zweimaligen Maßverlustes erreicht, da dieser jeweils mit unterschiedlichem Vorzeichen behaftet ist. Da der Maßverlust beim Ätzschritt über die Steuerung der vorausgegangenen chemischen Behandlung kompensierbar ist, läßt sich das gesamte Verfahren so einstellen, daß ein exakter 1:1-Strukturtransfer von der Maske in die untere Resiststruktur, bzw. in einem weiteren Ätzschritt von dieser Resiststruktur in das Substrat, z.B. einen Wafer, ermöglicht wird. Dabei ist der obere Resist (Topresist) frei wählbar mit der Maßgabe, daß er gegenüber der chemischen Behandlung nicht empfindlich ist. Er kann sowohl einen Positiv- als auch einen Negativresist darstellen und sollte bei der gegebenen Wellenlänge gut strukturierbar sein.

Die untere Resistschicht ist ebenfalls frei wählbar und muß nur eine Empfindlichkeit gegenüber der chemischen Behandlung aufweisen. Auch sollte sie sich nicht in der oberen Resistschicht, (bzw. deren Lösungsmittel) lösen. Von Vorteil ist weiterhin eine gewisse Wärmebeständigkeit dieser Bottomresist genannten unteren Resiststruktur, da bei den im Plasmaätzverfahren auftretenden höheren Temperaturen sonst ein Verfließen der Strukturen und somit eine ungenaue Strukturübertragung erfolgt. Gegenüber dem Entwicklungsverfahren des Topresists muß der Bottomresist unempfindlich sein und soll dabei während des ganzen Verfahrens eine gute Haftung zum Topresist aufweisen.

Die chemische Behandlung wird mit einem Agens vorgenommen, welches in einer Lösung oder Emulsion vorliegen kann. Vorteilhaft bezüglich der Handhabung ist ein in flüssiger Phase vorliegendes Agens, insbesondere wenn das Lösungsmittel Wasser ist oder zumindest Wasser als Lösungsmittelbestandteil enthält. Die Behandlung kann dann in offenen einfachen Apparaturen in einem Sprüh-, Puddle- oder Tauchentwickler durchgeführt werden.

Die Reaktion der Bottomresistoberfläche in den freigelegten Bereichen mit dem Agens wird über die Dauer der chemischen Behandlung gesteuert. Bei zunehmender Behandlungsdauer werden die durch die freigelegten Bereiche definierten Bottomresiststrukturen, bzw. die durch die chemische Behandlung ätzresistent gemachten Strukturen verbreitert. Diese Unterdiffusion in benachbarte Schichtbereiche des mit der Topresiststruktur bedeckten Bottomresists kann auch über die Temperatur gesteuert werden, bei der die chemische Behandlung vorgenommen wird. Bei Behandlung mit einem in flüssiger Phase vorliegenden Agens kann die Verbreiterung der Bottomresiststrukturen auch über eine höhere Konzentration des Agens beschleunigt werden, bzw. dadurch bei konstanter Behandlungsdauer eine größere Verbreiterung der Bottomresiststrukturen erzielt werden.

Durch die chemische Behandlung mit dem Agens wird eine erhöhte Ätzresistenz der behandelten Bottomresiststrukturen erzielt. Dazu werden z.B. metallorganische bzw. metallhaltige organische Verbindungen an den Bottomresist angebunden, die in einem sauerstoffhaltigen Ätzplasma nichtflüchtige Oxide bilden. In einer Ausführungsform der Erfindung werden dazu mit Hilfe eines siliziumhaltigen Agens siliziumhaltige Reste an den Bottomresist angebunden. Die Anbindung erfolgt an entsprechend reaktive Gruppen im Bottomresist, wobei auch das Agens entsprechend reaktionsfähige funktionelle Gruppen trägt.

Für den Bottomresist wird vorteilhafterweise ein Polymer gewählt, welches Anhydrid- oder Epoxidfunktionen als reaktive Gruppen aufweist. Zur Reaktion mit diesen ist eine Vielzahl von Gruppen geeignet. So kann das Agens z.B. eine der folgenden Funktionen enthalten: Alkohol, Amin, Thiol, Imid oder Carbonsäure.

Vorteilhafterweise wird für das erfindungsgemäße Verfahren ein Agens eingesetzt, welches zumindest eine Aminogruppe aufweist. Insbesondere aliphatische Aminosilane und Aminosiloxane sind gut geeignet. Beispielsweise kann ein Agens einer der folgenden Strukturformen gehorchen, $R^1-(CH_2)_n-SiR^2_3$

$R^2_3$ Si-NH-$SiR^2_3$

wobei $R^1$ gleich NHR, -SH, -OH oder -COOH ist und die Reste $R^2$ unabhängig voneinander für Metyhl, Phenyl, Methoxy, Oxyphenyl oder Trimethylsilyloxy stehen, n eine ganze Zahl mit $10 \geqq n \geqq 1$ und R = H, Alkyl, Aryl.

Bessere Ergebnisse als mit einem monofunktionellen Agens werden mit einem Di- oder mehrfunktionellen Agens erzielt. Ein solches zeigt eine schnellere Reaktion mit den reaktiven Gruppen des Bottomresists und führt zur Vernetzung der chemischen Struktur des Bottomresists. Durch die Vernetzung wird der Bottomresist in seinen chemisch-physikalischen Eigenschaften verbessert und zeigt insbesondere eine höhere Ätzresistenz und eine höhere Erweichungstemperatur als ein entsprechender unvernetzter Resist. Ein mehrfunktionelles Agens gehorcht deshalb z.B. einer der folgenden Strukturen:

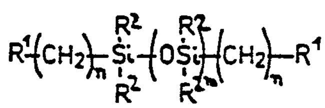
(m=0-30, n=0-3)

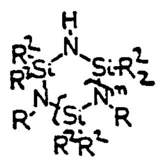
(n>1)

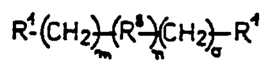
(m,o ≥ 1, n ≥ 0)

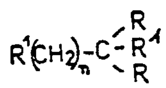
(n ≥ 0)

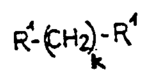
(k ≥ 1)

wobei die Reste $R^1$ und $R^2$ die bereits angegebenen Bedeutungen haben können, $R^3$ für H, Alkyl oder Aryl steht und $R^8$ für -O-, -NH-, -S-,

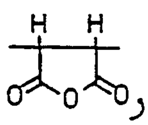, 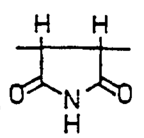, 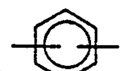, 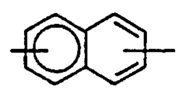

steht.

Das Molgewicht bzw. die Molekülgröße des Agens wird nach oben hin durch die geforderte Diffusionsfähigkeit begrenzt. Die Reaktion des Agens mit dem Bottomresist findet nicht nur an der Oberfläche statt, sondern erfaßt durch Diffusion des Agens in den Resist auch tiefergelegene Bereiche, bzw. durch laterale Diffusion auch seitlich benachbarte Schichtbereiche der freigelegten Bottomresistoberfläche. Die Molekülgröße des Agens ist also so gewählt, daß die Diffusion in den Bottomresist und auch in bereits behandelte Bereiche des Bottomresist nicht behindert wird. Als Triebkraft für die Diffusion dient ein chemisches Potentialgefälle vom Medium des Agens hin zum Bottomresist.

Ein weiterer vorteilhafter Aspekt des erfindungsgemäßen Verfahrens ist der Volumenzuwachs, der durch die Anbindung von Gruppen an den Bottomresist erzielt wird. Dieser führt zu einem Aufdicken der behandelten Bereiche und erhöht somit die Schichtdicke der ätzresistent gemachten Strukturen. Da eine dickere Schicht einem Ätzplasma auch entsprechend länger widersteht, erhöht sich auch dadurch die Ätzresistenz dieser Strukturen.

Im folgenden wird die Erfindung anhand von zwei Ausführungsbeispielen, je zwei Zusammensetzungen für die dabei verwendeten Resists und anhand von drei Figuren näher erläutert. Die Figuren verdeutlichen im schematischen Querschnitt durch eine Resiststruktur verschiedene Stufen des erfindungsgemäßen Verfahrens.

1. Ausführungsbeispiel

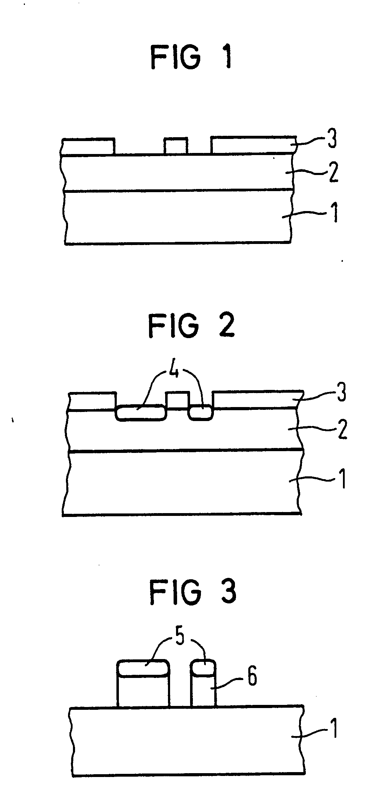

Ein Siliziumwafer (1) wird mit dem Bottomresist B1 (2) beschichtet und bei 100° C für 60s auf dem hotplate getrocknet, so daß eine Schichtdicke von 1800 nm erhalten wird. Darüber wird der Topresist T1 aufgebracht und ebenfalls bei 100° C getrocknet, so daß eine Schichtdicke von 400 nm erhalten wird. Nach Belichtung des Topresists mit einer Dosis von 300 mJ/cm$^2$ auf einer DUV-Kontaktbelichtungsanlage, einem post-exposure-bake bei 140° C für 60 s auf dem hotplate und 40 s Entwicklung mit Isoproponol wird ein negatives Abbild (3) der Maske erhalten (siehe Fig. 1). Der so strukturierte Wafer wird nun so lange in das Silylierungsagenz Al getaucht, daß nach dem Abspülen mit Isopropanol und Trocknen beim Bottomresist B1 an den vom Topresist freigelegten Bereichen ein Schichtzuwachs (4) von 250 nm zu verzeichnen ist (siehe Fig. 2). Nach 2minütiger Ätzung des so behandelten Wafers im Sauerstoffplasma bei einer Leistung von 1 kW und einem Druck von 2,5 nm Torr werden maßhaltige submicrometer Strukturen (5,6) erhalten, die ein positives Abbild der Maske darstellen (siehe Fig. 3).

Durch eine Verlängerung oder Verkürzung der Behandlungszeit in der Silylierungslösung können diese Strukturen verbreitet oder verschmälert werden.

2. Ausführungsbeispiel

Ein Siliziumwafer (1) wird mit dem Bottomresist B2 (2) beschichtet und bei 100° C für 60 s auf dem hotplate getrocknet, so daß eine Schichtdicke von 1800 nm erhalten wird. Darüber wird der Topresist T2 aufgebracht und ebenfalls bei 100° C getrocknet, so daß eine Schichtdicke von 600 nm erhalten wird. Nach Belichtung des Topresists mit einer Dosis von 300 mJ/qcm auf einer Kontaktbelichtungsanlage für nahes UV-Licht, einem post-exoposure-bake bei 100° C für 60 s auf dem hotplate und 60 s Entwickltung mit dem Entwickler AZ 312-27 wird ein negatives Abbild (3) der Maske erhalten.

Der so strukturierte Wafer wird nun mit tiefen UV-Licht ganzflächig mit einer Dosis von 200 mJ/cm$^2$ belichtet und dann so lange in das Silylierungsagenz A1 getaucht, daß nach dem Abspülen mit Isopropanol und Trocknen sich der Topresist T2 abgelöst hat und beim Bottomresist B2 an den vom Topresist für die Flutbelichtung freigelegten Bereichen ein Schichtzuwachs von 250 nm zu verzeichnen ist. Nach 2 minütiger Ätzung des so behandelten Wafers im Sauerstoffplasma bei einer Leistung von 1 kW und einem Druck von 2,5 m Torr werden maßhaltige submicrometer Strukturen erhalten, die ein positives Abbild der Maske darstellen.

Durch eine Verlängerung oder Verkürzung der Behandlungszeit in der Silylierungslösung können diese Strukturen verbreitert oder verschmälert werden.

## Ansprüche

1. Verfahren zur lithographischen Strukturübertragung mit Hilfe eines Zweilagenresistsystems, bei welchen

a) auf einem Substrat eine erste planarisierte Resistschicht aufgebracht wird,

b) darüber eine zweite, ausreichend dünne photolithographisch strukturierbare Resistschicht erzeugt, über eine Maske belichtet und entwickelt wird, wobei Bereiche der ersten Resistschicht freigelegt werden,

c) das Matrial der ersten Resistschicht in den freigelegten Bereichen mit einem in flüssiger Phase vorliegenden Agens chemisch behandelt wird, um eine Ätzresistenz gegen ein gegebenes Trockenätzverfahren zu erzeugen,

d) dieses Trockenätzverfahren schließlich durchgeführt wird, um die zweite Resistschicht vollständig und die erste Resistschicht anisotrop bis auf die freigelegten, chemisch behandelten und veränderten Bereiche abzutragen, wobei die entstehende Struktur aus den chemisch veränderten Bereichen der ersten Resistschicht besteht und ein Negativbild der in der zweiten Resistschicht gebildeten Struktur darstellt.

2. Verfahren nach Anspruch 1, **dadurch gekennzeichnet,** daß die Behandlung eine kontrollierbare isotrope Wirkung aufweist, bei der durch Unterdiffusion unter die aus der zweiten Resistschicht gebildete Struktur auch benachbarte Gebiete der nicht freigelegten Bereiche erfaßt werden, wobei eine Verbreiterung der ätzresistenen Strukturen erzielt wird, und daß das Ausmaß der Strukturverbreiterung gesteuert wird.

3. Verfahren nach Anspruch 1 oder 2, **dadurch gekennzeichnet,** daß die chemische Behandlung so gesteuert wird, daß die erzielte Strukturverbreiterung genau einem solchen Maßvorhalt entspricht, daß der laterale Maßverlust, der bei einem weiteren, später durchzuführenden Ätzprozeß zur Strukturierung des Substrats auftritt, ausgeglichen wird.

4. Verfahren nach Anspruch 3, **dadurch gekennzeichnet,** daß die Strukturverbreiterung über die Dauer der chemischen Behandlung gesteuert wird.

5. Verfahren nach einem der Ansprüche 1 bis 4, **dadurch gekennzeichnet,** daß die erste Resistschicht in den freigelegten Bereichen vor der chemischen Behandlung flutbelichtet wird, wobei die zweite Resiststruktur als Maske wirkt.

6. Verfahren nach mindestens einem der Ansprüche 1 bis 5, **dadurch gekennzeichnet,** daß das Trockenätzverfahren in einem Sauerstoff/RIE-Plasma durchgeführt wird.

7. Verfahren nach mindestens einem der Ansprüche 1 bis 6, **dadurch gekennzeichnet,** daß die chemische Behandlung mit einem siliziumhaltigen Reagenz durchgeführt wird, wodurch siliziumhaltige Reste an entsprechend reaktive Gruppen der ersten Resistschicht gebunden werden.

8. Verfahren nach mindestens einem der Ansprüche 1 bis 7, **dadurch gekennzeichnet,** daß für die erste Resistschicht ein Polymer gewählt wird, welches Anhydrid-, Imid- oder Epoxidfunktionen als reaktive Gruppen aufweist, an welche durch chemische Behandlung ätzresistente Gruppen angebunden werden können.

9. Verfahren nach Anspruch 8, **dadurch gekennzeichnet,** daß die chemische Behandlung mit einem Reagenz durchgeführt wird, welches zur Reaktion mit den reaktiven Gruppen zumindest eine der folgenden Funktionen aufweist: Alkohol, Amin, Thiol, Carbonsäure oder Epoxid.

10. Verfahren nach mindestens einem der Ansprüche 1 bis 9, **dadurch gekennzeichnet,** daß die chemische Behandlung mit einer Lösung oder Emulsion in wässrigem oder zumindest Wasser enthaltendem Medium durchgeführt wird.

11. Verfahren nach mindestens einem der Ansprüche 1 bis 10, **dadurch gekennzeichnet,** daß das Agens zur chemischen Behandlung einer der folgenden Strukturformeln gehorcht,

$R^1\text{-}(CH_2)_n\text{ - }SiR^2_3$

$R^2_3\text{ Si - NH - Si }R^2_3$

wobei $R^1$ = - NHR, -SH, -OH, $R^2$ für Methyl, Phenyl, Methoxy, und Oxyphenyl oder Trimethylisilyoxy steht, R = H, Alkyl, Aryl ist und

$10 \geqq n \geqq 1$

ist.

12. Verfahren nach mindestens einem der Ansprüche 1 bis 11, **dadurch gekennzeichnet,** daß das Reagenz zur chemischen Behandlung einer der folgenden Formeln gehorcht,

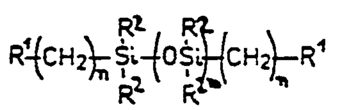

$(m = 0\text{-}30,\ n = 0\text{-}3)$

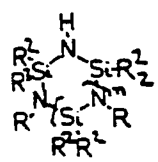

$(n > 1)$

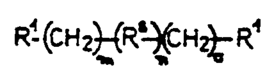

$(m, o \geq 1,\ n \geq 0)$

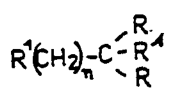

$(n \geq 0)$

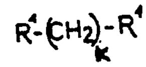

$(k \geq 1)$

wobei die Reste den bereits angegebenen Bedeutungen entsprechen.

13. Verfahren nach mindestens einem der Ansprüche 1 bis 12, **dadurch gekennzeichnet,** daß die chemische Behandlung mit einem Diaminosiloxan durchgeführt wird.

FIG 1

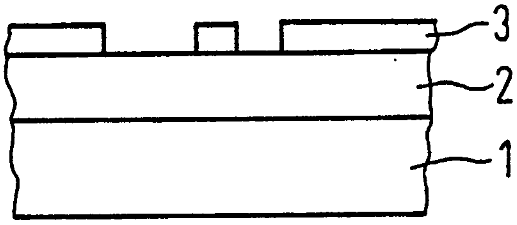


FIG 2

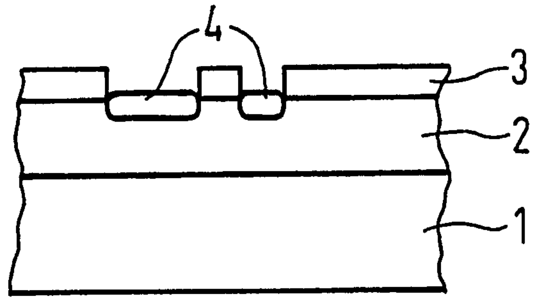


FIG 3